# EUROPEAN PATENT APPLICATION

(11) **EP 3 293 773 A1**
(43) Date of publication of application: **14.03.2018**
(21) Application number: 16796371.9
(22) Date of filing: 11.05.2016
(51) Int. Cl.: H01L 31/0352, B82Y 30/00, H01L 31/068

(54) **SOLAR CELL COMBINED WITH MOLECULE-TERMINATED SILICON NANOPARTICLES**

(30) Priority: 21.05.2015 JP 2015103575
(71) Applicant: National Institute for Materials Science, Tsukuba-shi, Ibaraki 305-0047 (JP)
(72) Inventor: FUKATA, Naoki, Tsukuba-shi, Ibaraki 305-0047 (JP); DUTTA, Mrinal, Tsukuba-shi, Ibaraki 305-0047 (JP)
(74) Representative: Markfort, Iris-Anne Lucie
(86) International application number: PCT/JP2016/064037
(87) International publication number: WO 2016/185978

(57) **Abstract**

[Object] To improve the photoelectric conversion efficiency of a p-n junction solar cell by adding a minimum element thereto to widen the absorption wavelength range thereof.

[Solving Means] Nano particles obtained by terminating surfaces of silicon nanoparticles having a diameter of not more than 5 nm with molecules of hydrocarbon are disposed on the outermost surface of a semiconductor forming a p-n junction solar cell that uses silicon or the like. These silicon nanoparticles absorb energy of ultraviolet light, and the energy is transferred to the p-n junction solar cell. In this way, a solar cell composite that efficiently utilizes light ranging to the ultraviolet region without requiring the use of additional wiring or the like is obtained.

## Description

### Technical Field

The present invention relates to a solar cell composite with improved conversion efficiency of a p-n junction solar cell (hereinafter, referred to simply as a solar cell) by disposing molecule-terminated silicon nanoparticles on a surface of the solar cell by arbitrary means such as coating, and transferring solar energy absorbed by the molecule-terminated silicon nanoparticles to a bottom silicon solar cell layer.

### Background Art

Currently, a solar cell utilizing polycrystalline silicon is mainly used as a solar cell material from the viewpoint of safety of raw materials, abundance of resources, a production cost, and conversion efficiency. However, even though the conversion efficiency is relatively high, the theoretically derived maximum conversion efficiency of the solar cell utilizing polycrystalline silicon is approximately 28.5%, and it is desired to improve the efficiency by utilizing new technologies/concepts.

Various attempts have been made to increase the conversion efficiency of a silicon-based solar cell. One of them is a surface passivation technology (Non-Patent Literature 1). This technology is performed for suppressing the reduction in conversion efficiency due to recombination of carriers on the surface. Meanwhile, it is also a very important problem in improving conversion efficiency to improve utilization efficiency of solar energy with wide wavelength distribution by a tandem structure or composite of dissimilar materials.

However, in the former case, the theoretical upper limit of conversion efficiency remains as it is, and improvement of conversion efficiency becomes rapidly difficult as the conversion efficiency of the solar cell approaches the theoretical efficiency. Further, in the latter case, although it is certainly possible to realize high conversion efficiency, it is very difficult to reduce the price strongly demanded for the solar cell due to an increase in the number of processes for preparing a conversion device and expensive used raw materials, and the toxicity of the used raw materials is also a problem.

Further, since a tandem structure solar cell basically has a structure where solar batteries optimized for each wavelength band are laminated and connected in series to each other, it is necessary to match the current flowing through these solar batteries connected in series. Due to this series structure, there is a problem that the conversion efficiency is significantly reduced under irradiation conditions (cloudy weather, morning and evening, and the like) deviating from the solar spectrum distribution (e.g., AM 1.5 G) assumed when designing a tandem structure solar cell, and the difference between the average conversion efficiency during the actual operation throughout the year and the conversion efficiency under optimal conditions is large. Although also an improved tandem structure solar cell having a parallel connection configuration has been proposed, it is not necessarily advantageous because the structure of the originally complicated tandem structure solar cell is further complicated by this improvement.

### Disclosure of Invention

### Technical Problem

It is an object of the present invention to improve the conversion efficiency of the silicon-based solar cell irrespective of the theoretical conversion efficiency by adding a simple structure using no special material. Solution to Problem

According to an aspect of the present invention, there is provided a solar cell composite, wherein silicon nanoparticles are provided on an outermost surface of semiconductor, the semiconductor forming a p-n junction solar cell for converting at least part of irradiated light in the visible light range to electricity, and wherein at least some of the silicon nanoparticles are not greater than 5 nm in diameter and their surfaces are terminated with hydrocarbons of not greater than 5 nm in molecular length, whereby the silicon nanoparticles absorb irradiated ultraviolet and perform energy transfer to the solar cell.

The hydrocarbon may be an alkene or an alkane.

Further, the p-n junction solar cell may be a silicon p-n junction solar cell.

Further, the semiconductor may include a silicon nanowire provided on a silicon substrate.

Further, the silicon nanowire may be embedded in a silicon matrix, and the outermost surface of the semiconductor may be a surface of the silicon matrix. Advantageous Effects of Invention

According to the present invention, it is possible to easily increase the energy conversion efficiency of the silicon-based solar cell by only coating silicon particles terminated with molecules on the silicon-based solar cell. Brief Description of Drawings
[Fig. 1] Fig. 1 is a production process diagram of molecule-terminated silicon nanoparticles.
[Fig. 2] Fig. 2 is a graph showing (a) a high resolution transmission electron microscopy image and (b) a surface analysis result by Fourier transform infrared absorption spectroscopy of silicon particles terminated with 1-octadecene.
[Fig. 3] Fig. 3 shows (a) a scanning microscopy image of an n-type silicon nanowire array on a silicon substrate formed by electroless etching, (b) a scanning electron microscopy image of a p-type silicon layer formed on a surface of the n-type silicon nanowire array by CVD, (c) a photograph of a cell of the solar cell, and (d) a schematic diagram of the structure of a finally produced solar cell.
[Fig. 4] Fig. 4 is a graph showing results of (a) solar cell characteristics (I-V characteristics) evaluation and (b) external quantum effect measurement in the case where silicon particles terminated with 1-octadecene are used (with SiQDs) and in the case where silicon particles terminated with 1-octadecene are not used (with no SiQDs).
[Fig. 5] Fig. 5 is a graph showing photoluminescence lifetime measurement results of silicon particles terminated with 1-octadecene on a silicon substrate and a glass substrate.

### Mode(s) for Carrying Out the Invention

According to an embodiment of the present invention, conversion efficiency of a solar cell is improved by coating molecule-terminated silicon nanoparticles on the outermost surface of a semiconductor forming a p-n junction silicon solar cell (hereinafter, a p-n junction silicon solar cell is referred to simply as a silicon solar cell), increasing the light absorption sensitivity of the wavelength of sunlight, particularly in the ultraviolet region, and transferring the solar energy absorbed by the molecule-terminated silicon nanoparticles to a bottom silicon layer.

The band gap of bulk Si is approximately 1.1 eV at room temperature. As the size decreases as in nanoparticles, the band gap increases. In the case where the diameter of the nanoparticles becomes not more than 5 nm, the band gap increases from approximately 1.5 eV to 3 eV depending on the size (Non-Patent Literature 3). Nanoparticles have higher light absorption efficiency than bulk materials, and have high sensitivity particularly with respect to ultraviolet light.

Normally, the surfaces of silicon nanoparticles are each covered with an oxide film of 1 to 2 nm, and there are dangling-bond-type defects (unbonded bond where atoms are not bonded to each other) at the interface. In the case where there are dangling-bond-type defects at the interface or on the surface, light-induced carriers induced by absorption of sunlight recombine with deep levels formed by the defects, making it difficult to effectively take out carriers (electricity). Meanwhile, in the case where the surfaces of silicon nanoparticles can be completely terminated with chemical species, no defects are formed at the interface unlike the case where they are each covered with an oxide film, and they can be used as a favorable absorbing material for solar power generation.

In this regard, a structure where molecule-terminated silicon nanoparticles are provided on a surface of a silicon-based solar cell by arbitrary means such as coating will be considered. In the case where the surfaces of silicon nanoparticles are terminated with molecules, light-induced carriers generated in the silicon nanoparticles by absorption of sunlight cannot be transferred to the underlying silicon solar cell by charge transfer. This is because the molecular termination on the surface interferes with the charge transfer. Therefore, electrons and holes as the light-induced carriers generated in the silicon nanoparticles by absorption of sunlight eventually recombine. At this time, in the case where the recombination energy can be non-radiatively transferred to the underlying silicon solar cell, in other words, in the case where the inside of the solar cell can be efficiently excited by the energy generated by the recombination, the number of carriers generated therein increases and the current value that can be taken out as the solar cell increases as a result. This is the principle that the current value is increased by energy transfer and the conversion efficiency increases. Note that from the viewpoint of an equivalent circuit, the current excited in the silicon solar cell by the energy transferred from silicon nanoparticles to the underlying silicon solar cell is current added by connecting a current source corresponding to the current excited by the energy transferred from the silicon nanoparticles to a current source corresponding to the current generated by the original solar cell function on the side of the silicon solar cell in parallel. Therefore, it should be noted that in the present invention, the original solar cell function on the side of the silicon solar cell and the operation of exciting current therein by the energy transferred from the silicon nanoparticles to the silicon solar cell are essentially independent of each other, and it is unnecessary to match the current generated from them.

Note that the destination of transfer by the above-mentioned energy transfer of the solar energy absorbed by the nanoparticles needs to be, for example, bulk silicon or a silicon nanowire having one-dimensional structure excellent in carrier transport even in nanostructure. In this case, the effective length of the molecules terminating the surfaces of silicon particles and the kind of molecule are important. In the example of the present invention described below, 1-octadecene was adopted as molecular species. As described above, by setting the molecular length to approximately not more than 5 nm and terminating the surfaces of silicon nanoparticles with C-H bond, energy transfer from the silicon nanoparticles to the silicon solar cell material could be realized for the first time. Further, high efficiency as the whole system could be realized by combination with the nanowire structure, and a new silicon-based solar cell in which the conversion efficiency is not sensitively changed by the spectrum change of irradiation light could be realized. Note that there are effects of making dangling-bond-type defects as dangling bonds on the surfaces of the silicon nanoparticles electrically inactive, by terminating the surfaces of silicon nanoparticles with C-H bond, and suppressing re-oxidation of the surfaces of the silicon nanoparticles to suppress agglomeration of the silicon nanoparticles.

Note that although 1-octadecene has been described as molecules terminating the surfaces of the silicon nanoparticles as an example in the above, in addition thereto, an alkene or alkane satisfying the above-mentioned limitation of the molecular length can be used, for example. Molecules having a smaller molecular weight than 1-octadecene such as pentene and hexene may be used as the alkene, alkane, and the like. However, in the case where the carbon number is small, agglomeration of nanoparticles may easily occur when the nanoparticles are re-oxidized over time. Therefore, molecules for termination only needs to be appropriately selected depending on the specific structure, used materials, assumed usage environment, and the like of the solar cell composite.

As described above, since the band gap of silicon nanoparticles is larger than that of bulk silicon, the absorption efficiency is high particularly with respect to light in the ultraviolet region. In this regard, by coating molecule-terminated silicon nanoparticles on the outermost surface of the silicon solar cell and efficiently transferring the solar energy absorbed by the molecule-terminated silicon nanoparticles to the bottom silicon solar cell layer, the wavelength range to be photoelectrically converted as a whole of such a solar cell composite system spreads to the ultraviolet side as compared to the wavelength range in the case of the existing silicon-based solar cell alone, and the conversion efficiency of the solar cell can be easily improved.

This strategy of improving the conversion efficiency uses the result of light energy absorption with high efficiency performed in silicon nanoparticles totally independent of the existing silicon solar cell, and it is possible to improve the photoelectric conversion efficiency similarly to the existing solar cell having a tandem structure. Further, since light energy is converted finally into the form of electricity mainly on the side of the existing solar cell as the transfer destination of energy from silicon nanoparticles, it is unnecessary to provide a structure such as wiring routing to a place utilizing silicon nanoparticles, which makes manufacture easy. Further, in the present invention, since it is unnecessary to add components such as expensive or harmful elements/compounds, it is advantageous also in terms of production cost and safety. Further, as described above in detail, in the solar cell composite according to the present invention, when considered in terms of an equivalent circuit, since output of photoelectric conversion by light absorbed by the silicon solar cell and output of photoelectric conversion by light absorbed by the silicon nanoparticles are connected in parallel in the silicon solar cell, there is little influence on the conversion efficiency due to the spectrum change of irradiation light as compared with a typical solar cell having a tandem structure.

Further, the present invention is applicable also to a solar cell having a band gap smaller than that of silicon nanoparticles, e.g., a solar cell utilizing germanium.

### Example

In this example, silicon nanoparticles were coated on a sample obtained by embedding an n-type silicon nanowire in a p-type silicon matrix. The n-type silicon nanowire was formed on an n-type silicon substrate by electroless etching in which a silicon substrate was etched with silver nitrate (Non-Patent Literature 1). The p-type silicon matrix was formed by a chemical vapor deposition (CVD) method after the etching.

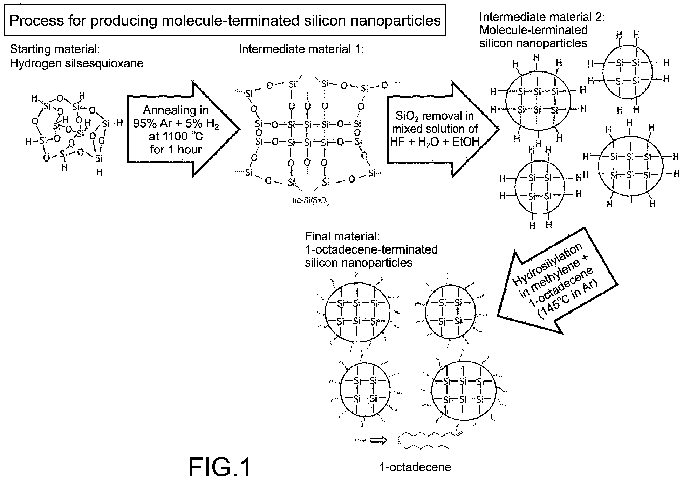

Regarding production of silicon nanoparticles, there are several methods. Typical examples thereof include a sputtering method (Non-Patent Literature 4), a laser ablation method (Non-Patent Literature 5), an etching method (Non-Patent Literature 6), and a method of reducing silicon oxide particles such as silsesquioxane (Non-Patent Literature 7) (Fig. 1). Although silicon nanoparticles produced in any of the methods can be used without problems, the important point is to make the diameter thereof not more than 5 nm. It goes without saying that silicon nanoparticles having a diameter exceeding 5 nm may be partially contained. However, in order to increase the photoelectric conversion efficiency, it is desirable that there are few nanoparticles having such oversized diameter.

Surfaces of normal silicon nanoparticles are easily oxidized in the atmosphere. Dangling-bond-type defects inevitably occur at the interface between the oxide film and the silicon crystal, which causes carriers generated by absorption of sunlight to recombine, leading to reduction in the conversion efficiency. In this regard, it is necessary to remove the surface oxide film with a hydrofluoric acid solution of approximately 1% before performing molecule termination, thereby converting the surface into the state of hydrogen termination.

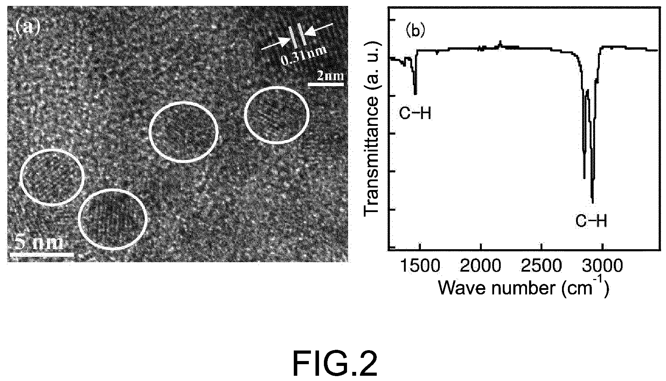

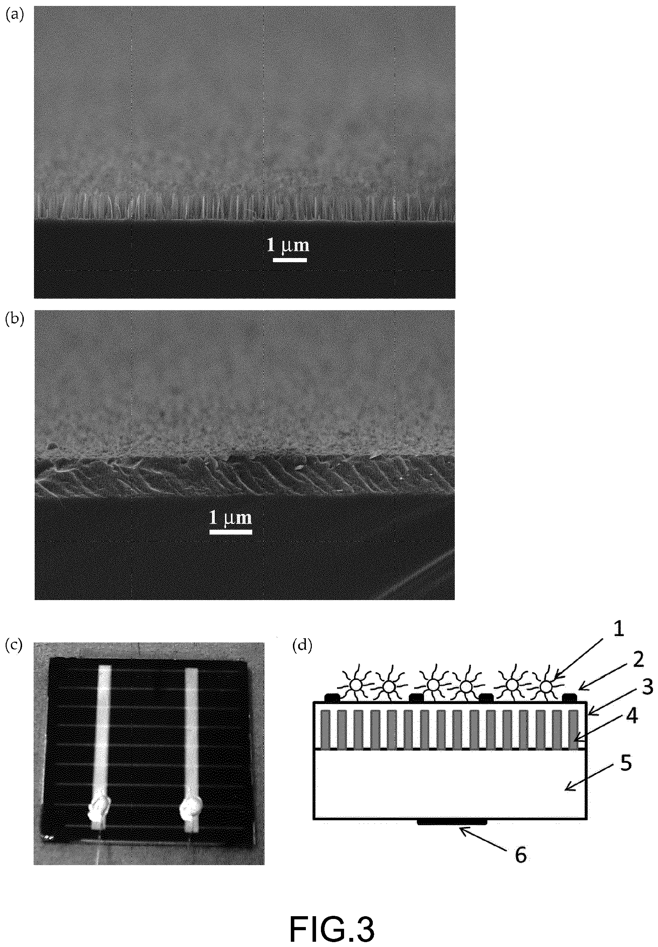

Next, molecule termination after the surface oxide film is completely removed will be described (Fig. 1). Fig. 1 is a production process diagram of molecule-terminated silicon nanoparticles. In the present invention, 1-octadecene was used for molecule termination. Silicon nanoparticles terminated with hydrogen were introduced into a mixed solution containing 5 mL of 1-octadecene and 5 mL of a methylene solution, and degassing was performed for 1 hour by bublling argon gas. After that, by performing heat treatment of 145°C for 5 to 10 hours in the argon gas atmosphere, silicon nanoparticles stably terminated with 1-octadecene are obtained (Fig. 2(a)). Fig. 2(a) is a high resolution transmission electron microscopy image of silicon particles terminated with 1-octadecene. As a result of examining the surface condition by Fourier transform infrared absorption spectroscopy (Fig. 2(b)), it was found that C-H bond was formed on each surface of the silicon nanoparticles. Fig. 2(b) is a graph showing a surface analysis result by Fourier transform infrared absorption spectroscopy. The generated silicon nanoparticles terminated with 1-octadecene were dispersed in a toluene solvent, coated on a surface of the silicon solar cell, and dried for 2 hours in vacuum. Fig. 3 shows a SEM image of a sample obtained by embedding an n-type silicon nanowire in a p-type silicon matrix, and a schematic diagram of the structure of a cell of a finally produced solar cell. Fig. 3(a) is a scanning microscopy image of an n-type silicon nanowire array on a silicon substrate formed by electroless etching, Fig. 3(b) is a scanning electron microscopy image of a p-type silicon layer formed on a surface of the n-type silicon nanowire array by CVD, Fig. 3(c) is a photograph of a cell of the solar cell, and Fig. 3(d) is a schematic diagram of the structure of a finally produced solar cell. In Fig. 3(d), molecule-terminated silicon nanoparticles 1, a surface electrode 2, a p-type silicon matrix 3, an n-type silicon nanowire 4, a silicon substrate 5, and a back surface electrode 6 are shown.

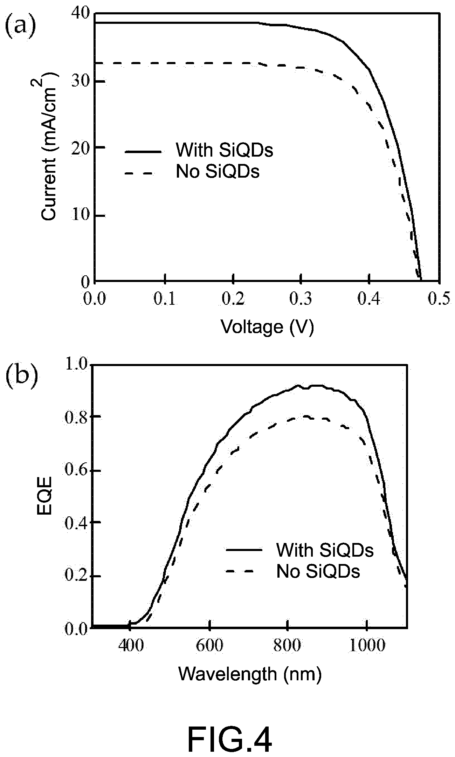

Fig. 4 shows the I-V measurement result performed for evaluating the characteristics of the solar cell composite produced in this way, and the result of examining the external quantum efficiency. In more detail, Fig. 4(a) is a graph showing results of solar cell characteristics (I-V characteristics) evaluation in the case where silicon particles terminated with 1-octadecene are used (with SiQDs) and in the case where silicon particles terminated with 1-octadecene are not used (with no SiQDs). Fig. 4(b) is a graph showing results of external quantum effect measurement in the case where silicon particles terminated with 1-octadecene are used (with SiQDs) and in the case where silicon particles terminated with 1-octadecene are not used (with no SiQDs). Here, a solar cell composite according to an example of the present invention and a solar cell for comparison having the same structure as that of the example except that silicon nanoparticles are not used, i.e., a structure where a silicon nanowire and a p-type silicon matrix are attached to the surface of the silicon solar cell, were compared with each other. As a result, although the open circuit voltage and structural factor are not changed in the example of the present invention and the solar cell for comparison, the short circuit current increased by approximately 16% and the conversion efficiency increased from 10.9% to 12.9% in the example of the present invention.

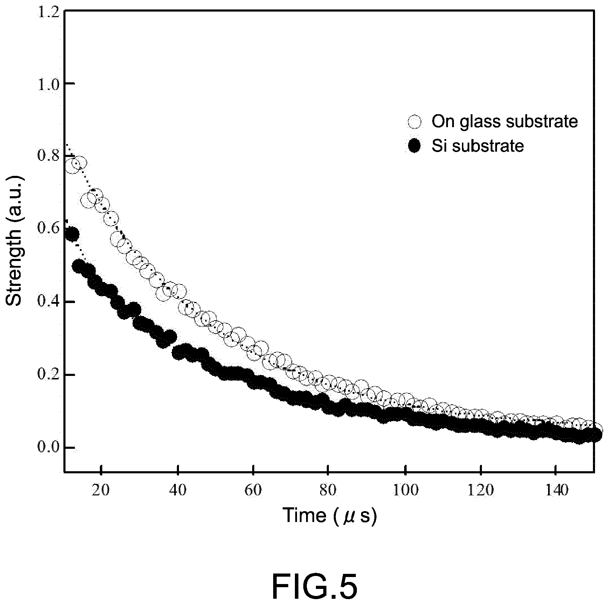

The increase in the short circuit current is due to energy transfer from the silicon nanoparticles to the underlying silicon solar cell layer. The energy transfer from the silicon nanoparticles to the underlying silicon solar cell layer is proved from the experimental result of photoluminescence in Fig. 5. Fig. 5 is a graph showing photoluminescence lifetime measurement results of silicon particles terminated with 1-octadecene on a silicon substrate and a glass substrate. Analysis of the results of examining the light emission lifetime of silicon nanoparticles in the case where the silicon particles terminated with 1-octadecene are dispersed on the glass substrate and the silicon substrate demonstrates that the light emission lifetime is significantly reduced in the case of the silicon substrate and the energy transfer from the nanoparticles to the underlying silicon substrate efficiently occurs in the case where the underlying substrate is a silicon substrate.

It goes without saying that the present invention is not limited to the abovementioned example, and various modifications can be made within the scope of the claims. For example, in the example illustrated and described above, the n-type silicon nanowire provided on the n-type silicon substrate was once embedded in the p-type silicon matrix, and the molecule-terminated silicon nanoparticles were coated on the surface of this silicon matrix. The reason why this structure is employed in the example is that the electrode structure (surface electrode 2) on the upper surface can be easily formed as compared with the nanowire, and contact with the electrode can be easily performed. Therefore, instead of completely embedding the silicon nanowire, a p-type silicon shell layer may be formed on the surface of the n-type silicon nanowire, and the silicon nanoparticles may be coated on the surface thereof. Further, the n-type layer and the p-type layer may be replaced with each other. In any of the structures, the same effects are expected, as energy transfer effects. As described above, in the present invention, it is possible to dispose silicon nanoparticles on arbitrary places where carriers that are constituent elements of a solar cell, receive energy of ultraviolet rays received by molecule-terminated silicon nanoparticles by energy transfer, and contribute to electric output from the solar cell can be generated. Note that regarding the disposition of silicon nanoparticles, it is favorable to dispose silicon nanoparticles not inside the solar cell but on the surface of the solar cell because the effects of silicon nanoparticles are reduced in the case where the ultraviolet absorption occurs to some extent before ultraviolet rays reaches the silicon nanoparticles even if the ultraviolet absorption rate of the silicon matrix or the like is low.

### Industrial Applicability

As described above, the present invention is expected to be industrially and widely used as a simple and new technology contributing to the increase in efficiency of a solar cell.

### Reference Signs List

- 1: molecule-terminated silicon nanoparticles
- 2: surface electrode
- 3: p-type silicon matrix
- 4: n-type silicon nanowire
- 5: silicon substrate
- 6: back surface electrode

### Citation List

### Non-Patent Document

Non-Patent Document 1: M. Dutta and N. Fukata, Nano Energy 11, 219-225 (2015).
Non-Patent Document 2: S. D. Wolf, A. Descoeudres, Z. C. Holman, and C. Ballif, Green 2, 7 (2012).
Non-Patent Document 3: T. Takagahara and K. Takeda, Phys. Rev. B46 (23), 15578-15581 (1992).
Non-Patent Document 4: K. Sato, H. Tsuji, K. Hirakuri, N. Fukata, and Y. Yamauchi, Chem. Commun. 25, 3759-3761 (2009).
Non-Patent Document 5: Koichi Murakami, Tetsuya Makimura, Naoki Fukada, Laser Research 33, 5-11(2005) S.
Non-Patent Document 6: S. Azuma and S. sato, Chem. Lett. 40 (11), 1294-1296 (2011).
Non-Patent Document 7: J. G. C. Veinot, Chem. Commun. 4160-4168 (2006).

## Claims

1. A solar cell composite,
wherein silicon nanoparticles are provided on an outermost surface of semiconductor, the semiconductor forming a p-n junction solar cell for converting at least part of irradiated light in the visible light range to electricity, and
wherein at least some of the silicon nanoparticles are not greater than 5 nm in diameter and their surfaces are terminated with hydrocarbons of not greater than 5 nm in molecular length,
whereby the silicon nanoparticles absorb irradiated ultraviolet and perform energy transfer to the solar cell.

2. The solar cell composite according to claim 1, wherein the hydrocarbon is an alkene or an alkane.

3. The solar cell composite according to claim 1 or 2, wherein
the p-n junction solar cell is a silicon p-n junction solar cell.

4. The solar cell composite according to claim 3, wherein
the semiconductor includes a silicon nanowire provided on a silicon substrate.

5. The solar cell composite according to claim 4, wherein
the silicon nanowire is embedded in a silicon matrix, and an outermost surface of the semiconductor is a surface of the silicon matrix.

## Amended claims

### Amended claims under Art. 19.1 PCT

1. (Currently Amended) A solar cell composite,
wherein silicon nanoparticles are provided on an outermost surface of semiconductor, the semiconductor forming a p-n junction solar cell for converting at least part of irradiated light in the visible light range to electricity, and
wherein at least some of the silicon nanoparticles are not greater than 5 nm in diameter and their surfaces are non-oxidized and terminated with hydrocarbons of not greater than 5 nm in molecular length,
whereby the silicon nanoparticles absorb irradiated ultraviolet and perform energy transfer to the solar cell.

2. The solar cell composite according to claim 1, wherein the hydrocarbon is an alkene or an alkane.

3. The solar cell composite according to claim 1 or 2, wherein
the p-n junction solar cell is a silicon p-n junction solar cell.

4. The solar cell composite according to claim 3, wherein
the semiconductor includes a silicon nanowire provided on a silicon substrate.

5. The solar cell composite according to claim 4, wherein
the silicon nanowire is embedded in a silicon matrix, and an outermost surface of the semiconductor is a surface of the silicon matrix.
